# EUROPEAN PATENT APPLICATION

(11) **EP 3 955 314 A1**
(43) Date of publication of application: **16.02.2022**
(21) Application number: 20190362.2
(22) Date of filing: 10.08.2020
(51) Int. Cl.: H01L 29/778, H01L 29/10, H01L 29/20, H01L 29/40

(54) **GROUP III NITRIDE DEVICE**

(71) Applicant: Infineon Technologies Austria AG, 9500 Villach (AT)
(72) Inventor: CURATOLA, Gilberto, 9500 Villach (AT); LAVANGA, Simone, 9500 Villach (AT); PRECHTL, Gerhard, 9232 Rosegg (AT); SICRE, Sebastien Bruno Franck, 9853 Faak am See (AT)
(74) Representative: Moore, Joanne Camilla

(57) **Abstract**

In an embodiment, a Group III nitride device (10, 10', 40, 50, 60, 70, 80), comprises a Group III nitride layer (11), a passivation layer(12) arranged on the Group III nitride layer (11) and comprising a first opening (13), a first ohmic contact structure (14, 14') arranged in the first opening (13) and forming an ohmic contact to the Group III nitride layer (11) and a charge injection barrier (15, 45, 55, 65, 85). The charge injection barrier (15, 45, 55, 65, 85) is arranged between the first ohmic contact structure (14, 14') and the passivation layer (12). The charge injection barrier (15, 45, 55, 65, 85) forms no ohmic contact to the Group III nitride layer (11).

## Description

### BACKGROUND

To date, transistors used in power electronic applications have typically been fabricated with silicon (Si) semiconductor materials. Common transistor devices for power applications include Si CoolMOS^{®}, Si Power MOSFETs and Si Insulated Gate Bipolar Transistors (IGBTs). More recently, silicon carbide (SiC) power devices have been considered. Group III nitride semiconductor devices, such as gallium nitride (GaN) devices, are now emerging as attractive candidates to carry large currents, support high voltages and to provide very low on-resistance and fast switching times. Further improvements to the performance and reliability of Group III nitride-based devices are, however, desirable.

### SUMMARY

According to the invention, a Group III nitride device is provided that comprises a Group III nitride layer, a passivation layer arranged on the Group III nitride layer and comprising a first opening, a first ohmic contact structure arranged in the first opening and forming an ohmic contact to the Group III nitride layer and a charge injection barrier that is arranged between the first ohmic contact structure and the passivation layer. The charge injection barrier forms no ohmic contact to the Group III nitride layer.

The charge injection barrier provides a barrier against leakage current from the first ohmic contact structure into the passivation layer and any other surrounding material.

In some embodiments, the charge injection barrier extends continuously and uninterruptedly between the first ohmic contact structure and the passivation layer to prevent surface-to-surface contact between the first ohmic contact structure and the passivation layer.

In some embodiments, the charge injection barrier extends continuously and uninterruptedly on side walls of the first opening and over an upper surface of the passivation layer.

In some embodiments, the charge injection barrier has a lateral extent on the upper surface of the passivation layer such that it forms a ring shape or a strip shape on the upper surface of the passivation layer.

In some embodiments, the charge injection barrier comprises at least one of the Group consisting of an oxide, a nitride, a metal nitride, TiN and a material having a work function that is higher than the work function of the first ohmic contact structure.

In some embodiments, the passivation layer comprises a nitride, for example a silicon nitride.

In some embodiments in which the passivation layer comprises a nitride, such as silicon nitride, the charge injection barrier comprises a nitride having a different composition and/or a higher density than the nitride of the passivation layer.

In some embodiments, the first ohmic contact structure comprises a first portion and a second portion, wherein the first portion has a first surface and a second surface opposing the first surface, the first portion extending in a transverse plane and having a width. The second portion protrudes from the second surface intermediate the width of the first portion. The second portion is arranged in the first opening of the passivation layer and the first portion extends onto the upper surface of the passivation layer adjacent the first opening.

The first ohmic contact may have a T-shape in cross-sectional view with the second portion providing a vertical portion and the first portion providing a horizontal portion. The first ohmic contact may have an elongate strip-like shape or a mushroom-type shape.

In some embodiments, Group III nitride device further comprises a second charge injection barrier covering the first surface of the first portion and a periphery of the first portion, the periphery extending from the first surface to the second surface.

In some embodiments, the first ohmic contact structure comprises aluminium and titanium and is free of copper and free of gold. The first ohmic contact may have a multilayer structure, for example a multilayer structure comprising a first titanium sublayer, an aluminium sublayer on the first titanium sublayer and a second titanium sublayer on the aluminium sublayer.

In some embodiments, the charge injection barrier comprises a first layer arranged on an upper surface of the passivation layer and a second layer arranged on side walls of the opening in the passivation layer. The first layer may comprise an oxide and the second layer may comprise a nitride.

In some embodiments, the charge injection barrier is arranged on the side walls of the first opening and extends onto the upper surface of the passivation layer, wherein a portion of the upper surface of the passivation layer is exposed from the charge injection barrier.

In some embodiments, the Group III nitride layer comprises a multilayer structure, the multilayer structure comprising a channel layer and a barrier layer on the channel layer forming a heterojunction with the channel layer.

In some embodiments, the Group III nitride device further comprises a second ohmic contact structure arranged on and forming an ohmic contact to the multilayer Group III nitride device structure, and a gate laterally positioned between the first ohmic contact structure and the second ohmic contact structure and forming a gate contact to the multilayer Group III nitride device structure to form a transistor device.

In some embodiments, the transistor device is a High Electron Mobility Transistor.

In some embodiments, the first ohmic contact structure is a drain contact and the second ohmic contact structure is source contact.

The gate may have a recessed gate structure and/or may include a gate insulation layer and/or include a p-doped Group III nitride layer under a metallic gate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a schematic cross-sectional view of a Group III nitride-based device according to an embodiment.
Figure 1B illustrates a schematic cross-sectional view of a Group III nitride-based device according to an embodiment.
Figure 2 illustrates a schematic cross-sectional view of an ohmic contact for a Group III nitride-based device according to an embodiment.
Figure 3 illustrates a schematic cross-sectional view of an ohmic contact for a Group III nitride-based device according to an embodiment.
Figure 4 illustrates a schematic cross-sectional view of an ohmic contact for a Group III nitride-based device according to an embodiment.
Figure 5 illustrates a schematic cross-sectional view of an ohmic contact for a Group III nitride-based device according to an embodiment.
Figure 6 illustrates a schematic cross-sectional view of an ohmic contact for a Group III nitride-based device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{yG}a_{(1-y)}N), aluminum indium gallium nitride (AlₓIn_{y}Ga_{(1-x-y)}N) , gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

Passivation of the device surface of Group III nitride-based (GaN) HEMTs for power electronics has been found to affect both the device performance and also its reliability. One approach adopted for the first passivation layer is a silicon nitride passivation that can be deposited according to different deposition methods, such as PECVD (Plasma Enhanced Chemical Vapour Deposition) and ALD (Atomic layer deposition) The passivation layer composition, the deposition method and deposition conditions such as temperature, pressure etc. strongly affect not only the static and dynamic performance of the GaN device but also play a major role in determining the overall device reliability. The passivation layer may be nitride-based, particularly for the lowermost or first passivation layer, or oxide-based.

The source and drain contacts of Group III nitride-based HEMTs are commonly referred to as ohmic contacts, also when the contact behaviour is not entirely ohmic. Carrier injection from the source and drain ohmic contacts into the passivation layer may, however, reduce performance and reliability of the device. According to embodiments described herein, a structure for the drain ohmic contact and optionally also the source ohmic contact is provided in order to limit the possible carrier injection into the passivation layer or layers. Possible unwanted parasitic paths for the leakage current include a leakage current due to current injection in the bulk of the passivation layer and/or at the interface between different passivation layers, and carrier injection from the drain contact via the passivation layer into the bulk of the GaN device.

According to the invention, a charge injection barrier is provided for an ohmic contact to prevent charge injection from the ohmic contact into the passivation layer and current leakage into the passivation layer. This enables the performance and reliability of the device to be improved.

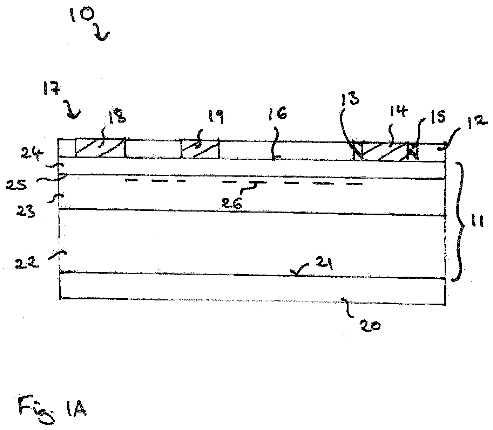

Figure 1A illustrates a schematic cross-sectional view of a Group III nitride-based device 10 according to an embodiment. The Group III nitride-based device 10 includes a Group III nitride layer 11 and a passivation layer 12 arranged on the Group III nitride layer 11. The passivation layer 12 comprises a first opening 13 for an ohmic contact to the Group III nitride device 10. The Group III nitride device 10 further includes a first ohmic contact structure 14 arranged in the first opening 13 of the passivation layer 12 which forms an ohmic contact to the Group III nitride layer 11. A charge injection barrier 15 is arranged between the first ohmic contact structure 14 and the passivation layer 12. The charge injection barrier 15 forms no ohmic contact to the Group III nitride-based Group III nitride layer 11.

The passivation layer 12 is arranged on an upper surface 16 of the Group III nitride layer 11. The opening 13 extends through the thickness of the passivation layer 12 such that the upper surface 16 of the Group III nitride layer 11 is exposed by and forms the base of the opening 13. The base of the ohmic contact structure 14 is in direct contact with the upper surface 16 of the Group III nitride layer 11. In other embodiments, the ohmic contact structure 14 is arranged in a recess in the upper surface 16 of the Group III nitride layer that is formed at the base of the opening 13.

In some embodiments, the passivation layer 12 is formed of a nitride, for example a silicon nitride. The ohmic contact structure 14 may comprise aluminium and titanium. In some embodiments, the ohmic contact 14 comprises aluminium and titanium and is free of copper and free of gold. The ohmic contact structure 14 may have a multilayer structure, whereby at least the lowermost layer that is in direct contact with the upper surface 16 of the Group III nitride layer 11 forms an ohmic contact with the Group III nitride layer 11.

In some embodiments, a Ti/Al/Ti stacked layer structure is used to creating a sort of Ohmic contact with reduced contact resistance to the Group III nitride layer 11. This stacked layer structure is commonly subjected to a thermal anneal to produce the ohmic contact with reduced resistance to the Group III nitride layer 11. Contact resistance values to a AlGaN layer which are as low as 0.2 Ohm*mm or lower such as 0.1 Ohm*mm have been achieved with this structure.

In order to provide a charge injection barrier 15 between the first ohmic contact structure 14 and the passivation layer 12, the charge injection barrier 15 may have the form of a layer which is positioned between the passivation layer 12 and the first ohmic contact structure 14 such that there is no surface to surface contact between the first ohmic contact structure 14 and the passivation layer 12. In some embodiments, the charge injection barrier 15 lines the sidewalls of the opening 13 whilst leaving the base of the opening 13 uncovered such that the material of the first ohmic contact structure 14 is in direct contact with the Group III nitride layer 11 so that an ohmic contact can be formed between the contact structure 14 and the Group III nitride layer 11.

In order to hinder charge injection from the ohmic contact structure 14 into the passivation layer 12, the layer 15 may extend continuously and uninterruptedly over the entire interfacial region between the passivation layer 12 and the ohmic contact 14 to prevent any surface to surface contact between the first ohmic contact structure 14 and the passivation layer 12. The charge injection barrier 15 also provides a barrier against leakage current from the first ohmic contact structure 14 into the surrounding material including the passivation layer 12 and any further material, for example, further insulating or dielectric layers of metallisation structure which are positioned on top of the first ohmic contact structure 14.

The charge injection barrier 15 may include an oxide, such as silicon oxide, a nitride, such as silicon nitride, a metal nitride, for example titanium nitride, or a material or metal having a work function that is higher than the work function of the first ohmic contact structure in order to hinder the injection of charges from the material of the first ohmic contact structure 14 into the first passivation layer 12.

In some embodiments, the Group III nitride layer 11 has a multilayer structure including two or more Group III nitride sublayers.

In some embodiments, the Group III nitride-based device 10 is a transistor device 17 such as a High Electron Mobility Transistor (HEMT). The first ohmic contact 14 may form an ohmic contact with a two-dimensional charge gas of the HEMT. In embodiments in which the Group III nitride device 10 is a transistor device 17, the first ohmic contact 14 may provide the drain contact of the transistor device.

In some embodiments, the Group III nitride device is a bidirectional switch or a light emitting diode.

The transistor device 17 includes a second ohmic contact 18 which provides a source contact and which is arranged on the upper surface 16 of the Group III nitride layer 11. The transistor device 17 further includes a gate contact 19 which is positioned on the upper surface 16 of the Group III nitride layer 11 and laterally between the source contact 18 and the first ohmic contact 14 which provides the drain contact of the transistor device 17.

The charge injection barrier 15 may be provided for only the drain contact 14 or may also be provided for the source contact 18.

The gate contact 15 may be a Schottky gate such that the base of the gate contact is formed of metal or alloy that forms a Schottky gate to the uppermost layer of the Group III nitride layer11. In other embodiments, the gate contact 15 may be an insulated gate contact.

In some embodiments, the gate contact 19 includes a p-doped Group III nitride layer which is positioned between a metallic gate contact and the Group III nitride layer 11 to form an enhancement mode device. In some embodiments, the gate contact 19 has a recessed gate structure.

In the transistor device 17, the Group III nitride layer 11 includes a multilayer structure. The multilayer structure includes a plurality of sublayers which may be formed on a substrate 20 by epitaxial growth of a plurality of Group III nitride layers on a growth surface 21 of the substrate 20. The substrate 20 may include a material other than the Group III nitride and be referred to as a foreign substrate. For example, the substrate 20 may be formed of monocrystalline silicon substrate, for example a <111> or <110> silicon wafer or a monocrystalline sapphire substrate, or an epitaxial silicon layer, which have a growth surface 21 that is capable of supporting the epitaxial growth of at least one Group III nitride layer. The substrate 20 may also be formed of SiC or AlN including a monocrystalline SiC or AlN substrate or epitaxial SiC or AlN layer.

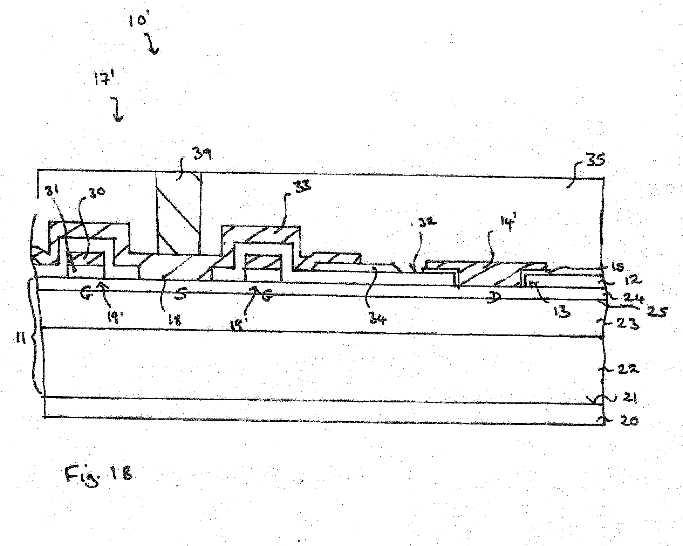

The multilayer structure may include a transition or buffer structure 22 which is epitaxially grown on the growth surface 21 of the substrate 20, a channel layer 23 arranged on the transition structure 22 and a barrier layer 24 arranged on the channel layer 23. The channel layer 23 and the barrier layer 24 have differing bandgaps such that a heterojunction 25 is formed the interface between the channel layer 23 and the barrier layer 24. The channel layer 23 may be formed of gallium nitride and the barrier layer 24 be formed of aluminium gallium nitride, for example. A two-dimensional charge gas, e.g. a two-dimensional electrode gas (2DEG) that is indicated schematically be in figure 1 by the dotted line 26 may be formed at the heterojunction 25. The transistor device 17 may be a normally on (enhancement mode) device or a normally off (depletion mode) device. The first ohmic contact 14 and the second ohmic contact 18 each provide an ohmic contact to the two-dimensional charge gas 26.

In embodiments, in which the ohmic contact structure 14 is arranged in a recess in the upper surface 16 of the Group III nitride layer that is formed at the base of the opening 13, the base of the recess may be positioned in and formed by the barrier layer 24.

In some embodiments, the Group III nitride layer 11 includes a further Group III nitride back barrier layer arranged between the channel layer 23 and the transition structure 22. The Group III nitride back barrier layer has a different bandgap from the channel layer 23 and may be formed of aluminium gallium nitride that may have the same or differing composition to the aluminium gallium nitride of the upper barrier layer 24.

A typical buffer structure 22 for a silicon substrate includes a AlN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer of AlGaN back barrier is grown. Alternatively, a superlattice buffer can be used. Again, an AlN starting layer on the silicon substrate is used. Depending on the chosen superlattice, a sequence of AlN and AlₓGa₍₁₋ₓ₎N pairs is grown, where the thickness of the AlN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice. In some embodiments, the superlattice buffer is carbon doped.

Figure 1B illustrates a schematic cross-sectional view of a Group III nitride device 10' comprising a lateral Group III nitride-based enhancement mode HEMT 17'. The HEMT 17' has a gate contact 19' includes a metal gate 30 and a p-doped Group III nitride layer 31 under the metal gate 30 to provide an enhancement mode transistor device 17'. The Group III nitride body 11 also includes a multilayer structure with an AlGaN barrier layer 24 positioned on a GaN channel layer 23.

The transistor device 17' includes a first ohmic contact structure 14' which provides the drain contact of the HEMT 17'. The first ohmic contact structure 14' is positioned in the opening 13 of passivation layer 12 and also extends over the upper surface 32 of the passivation layer 12 to form a T-shape. The second ohmic contact 18' providing the source contact of the transistor device 17' also has a T-shaped form with an upper portion extending over the upper surface 32 of the passivation layer 12. In the plane illustrated in figure 1B, the passivation layer 12 extends over the metallic layer 30 of the gate contact 19'.

The transistor device 17' also includes a field plate 33 which is connected to and extends from the source contact 18'. The field plate 33 extends in the direction of the drain contact 14' and is positioned above the gate contact 19'. A dielectric layer 34 is arranged on the upper surface 32 of the passivation layer 12 laterally adjacent and spaced apart from the drain side of the gate contact 19' and from the drain contact 14'. The dielectric layer 34 which may comprise an oxide, for example TEOS (Tetraethylorothosilicate). The field plate 33 extends onto the dielectric layer 34 to form a slanted or inclined structure away from the upper surface 32 of the passivation layer 12.

The HEMT 17' includes a metallisation structure on the upper surface 16 of the Group III nitride device 10' which includes an interlayer dielectric 35 which is positioned on the field plate 33, the dielectric layer 34, the first passivation layer 12, the source contact 18 and the drain contact 14'. In some embodiments, the interlayer dielectric 35 includes a stack of dielectric layers which may have different compositions. Also illustrated in figure 1B is a source contact via 39 which extends through the interlayer dielectric 35and is in contact with the upper surface of the T-shaped source contact 18'.

The first ohmic contact structure 14' has a general T-shape having a vertical portion position in the opening 13 and a horizontal or lateral portion which is in contact with the upper surface 32 of the passivation layer 12. The T-shaped first ohmic contact structure 14' can be considered to comprise a first portion and a second portion, whereby the first portion has a first surface and a second surface opposing the first surface, and extends in a transverse plane and has a width. A periphery of the first portion extends from the first surface to the second surface. The second portion protrudes from the second surface intermediate the width of the first portion. The second or vertical portion is arranged in the opening 13 of the passivation layer 12 and the first or horizontal portion extends onto the surface 32 of the passivation layer 12 adjacent the first opening 13.

Contact between the first ohmic contact structure 14' and the first passivation layer 12 is prevented by means of the charge injection barrier 15 that is arranged between the first ohmic contact structure 14' and the passivation layer 12. The charge injection barrier 15' is positioned on the side walls of the opening 13 in the passivation layer 12 and extends onto the upper surface 32 of the passivation layer 12 so as to prevent surface to surface contact between the outer surface of the vertical portion of the first ohmic contact 14' and the side wall of the opening 13 and between the lower surface of the horizontal portion of the first ohmic contact 14' and the upper surface 32 of the passivation layer 12. The charge injection barrier 15' may comprise an oxide layer, for example, a silicon oxide layer.

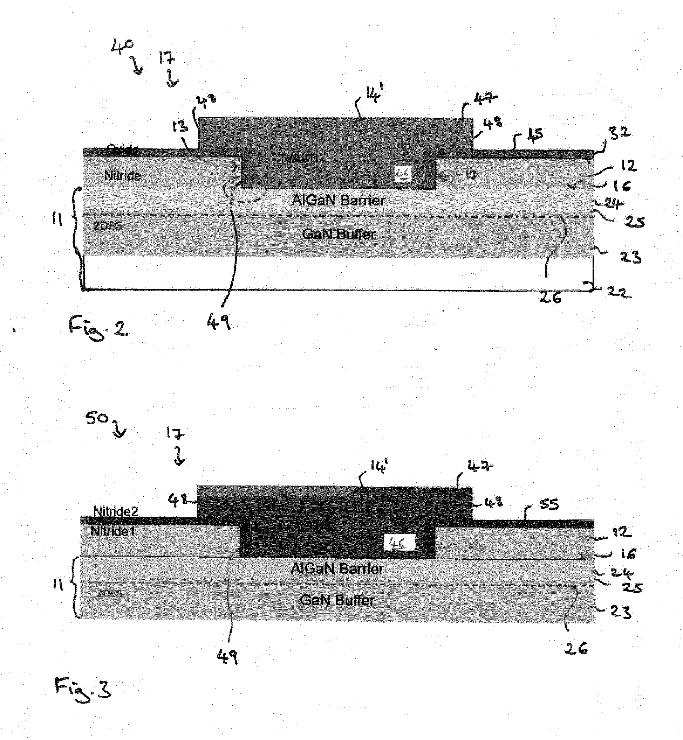

Figures 2 to 6 illustrate various embodiments of a charge injection barrier layer which may be used in a Group III nitride device including the Group III nitride device 10, 10' and Group III nitride-based transistor device 17, 17' illustrated in figures 1A and 1B.

Figure 2 illustrates a schematic enlarged view of a portion of a Group III nitride device 40 including a Group III nitride transistor device 17 and illustrates a T-shaped first ohmic contact structure 14' and a charge injection barrier 45 according to an embodiment. The first ohmic contact structure 14' may include a multilayer structure including sublayers of titanium, aluminium and titanium, for example. The first passivation layer 12 is arranged on the upper surface 16 of Group III nitride-based body 11 of which the AlGaN barrier layer 24 and the channel layer 23 with the heterojunction 25 and two-dimensional gas 26 are illustrated in figures 2 to 6.

The first ohmic contact structure 14' includes a T-shape with a vertical portion 46 and a horizontal portion 47. The vertical portion 46 is arranged in the opening 13 in the first passivation layer 12 and has a base that is in direct contact with the Group III nitride-based body 11. The horizontal portion 47 has a peripheral region 48 which is positioned above the first passivation layer 12 and laterally adjacent the opening 13.

The charge injection barrier 45 is positioned on the sidewalls 49 of the opening 13 and on the upper surface 32 of the first passivation layer 12 so as to form a continuous and uninterrupted barrier between the material of the first T-shaped first ohmic contact 14' and the first passivation layer 12. The charge injection barrier 45 includes a material that does not form an ohmic contact with the Group III nitride layer 11. In the embodiment illustrated in figure 2, the charge injection barrier 45 is formed of an oxide, for example silicon oxide. The charge injection barrier layer 45 has a lateral extent over the upper surface 32 of the passivation layer 12 which is at least as great as the overlap between the horizontal portion 57 of the first ohmic contact 14 and the first passivation layer 12.

Figure 3 illustrates a cross-sectional view of a portion of a Group III nitride device 50 including a Group III nitride-based transistor device 17 and in particular, the first ohmic contact structure 14 and a charge injection barrier layer 55. In the embodiment illustrated in figure 3, the charge injection barrier 55 is formed of a nitride, in particular a silicon nitride, which has a higher density than the silicon nitride forming the first passivation layer 12 that is arranged on the upper surface 16 of the Group III nitride layer 11. In this embodiment, the first ohmic contact structure 14' has a T-shape and the charge injection barrier 55 has a lateral extent such that it is positioned on the side faces 49 of the opening 13 in the first passivation layer 12 and extends over the upper surface 32 of the first passivation layer 12 continuously and uninterruptedly. Consequently, surface to surface contact between the vertical and horizontal portion of the first ohmic contact 14 and the first passivation layer 12 is prevented by the intervening section of the silicon nitride charge injection barrier 55. The first passivation layer 12 may extend continuously and uninterruptedly between the source and drain ohmic contacts of the transistor device 17.

In embodiments in which the passivation layer 12 is formed of a nitride material and the charge injection barrier 55 is formed nitride, the nitride of the charge injection barrier 55 may have a different composition to the nitride of the passivation layer 12 and/or may have a higher density than the nitride of the passivation layer 12 in order to act as a charge injection barrier.

In some embodiments, the charge injection barrier 45, 55 has a lateral extent which is less than the lateral extent of the underlying passivation layer 12. In embodiments in which the first ohmic contact structure 14' has an elongate stripe like shape, with the length of the stripe extending into the plane of the drawing, the charge injection barrier 45, 55 may also have also has a stripe like shape with the length of the stripe extending into the plane of the drawing.

In embodiments in which the first ohmic structure 14' has a circular form in plan view, the charge injection barrier 45, 55 forms a ring-shape on the upper surface 16 of the passivation layer 12, for example a circular ring-shape. If the first ohmic contact structure 14' has square shape or hexagonal shape in plan view, for example, the charge injection barrier 45, 55 also forms a square or hexagonal ring-shape on the upper surface 32 of the passivation layer 12 which has a width that is larger than the of the horizontal portion 47 of the first ohmic contact structure 14' such that the peripheral edge of the horizontal portion is arranged within the area of the charge injection barrier 45, 55.

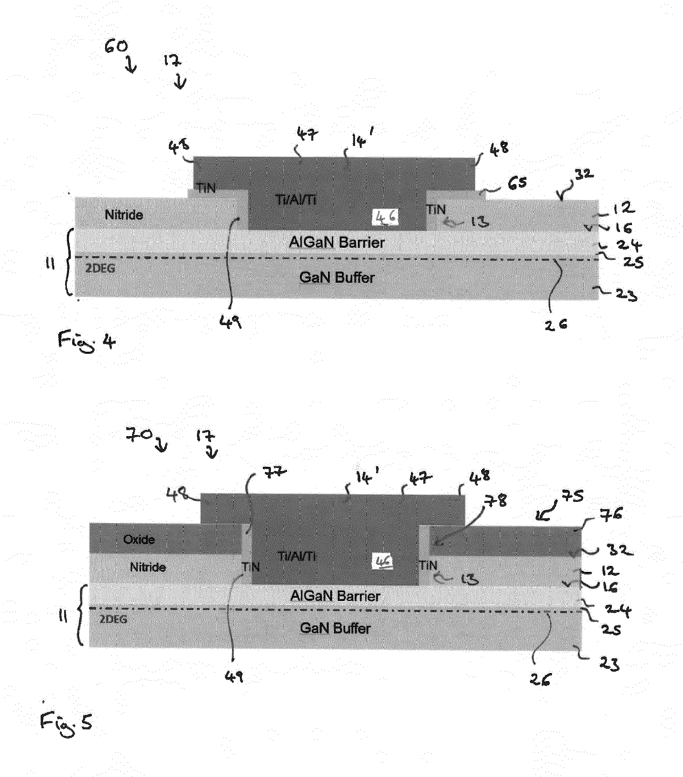

Figure 4 illustrates a schematic cross-sectional view of a portion of a Group III nitride device 60 including a Group III nitride transistor device 17, the first ohmic contact structure 14' to a Group III nitride layer 11 on which the passivation layer 12 is positioned. The first ohmic contact structure 14' has a T-shape with the vertical portion being positioned in the opening 13 of the passivation layer 12 and the horizontal portion extending over the upper surface 32 of the passivation layer 12 in regions adjacent the opening 13. In this embodiment, a charge injection barrier 65 is provided which is formed of a metallic conductive material, in particular titanium nitride, which does not form an ohmic contact to the Group III nitride layer 11 but has a work function which is higher than the work function of the materials forming the first ohmic structure 14' to prevent the injection of charge from the first ohmic contact structure 14' into the passivation layer 12.

The charge injection barrier 65 is positioned on the side faces 49 of the opening 13 and on the upper surface 32 of the first passivation layer 12 in regions immediately adjacent the opening 13.

The charge injection barrier 65 extends uninterruptedly on the sidewalls and edge of the opening 13 and also between the horizontal portion of the T-shaped first ohmic contact 14 and the underlying region of the upper surface 32 of the passivation layer 12 so as to prevent surface to surface contact between the first ohmic contact 14 and the first passivation layer 12. The charge injection barrier 65 has a lateral extent such that the upper surface 32 of the passivation layer 12 remains uncovered by the charge barrier layer 65 in regions laterally adjacent the first ohmic contact structure 14'. The lateral extent of the charge injection barrier 65 on the upper surface 32 of the first passivation layer 12 is larger than the lateral extent of the first ohmic contact structure 14' so as to prevent injection of charge from the first ohmic contact 14 into the first passivation layer 12.

Figure 5 illustrates a cross-sectional view of a portion of a transistor device 70 including a Group III nitride-based transistor device 17, the first ohmic contact structure 14' and a charge injection barrier layer 75. In the embodiment illustrated in figure 5, the charge injection barrier 75 includes two layers 76, 77. The first layer 76 is formed on the upper surface 32 of the first passivation layer 12. The first layer 76 is formed of an oxide, e.g. silicon oxide, and the first passivation layer 12 is formed of a nitride, e.g. silicon nitride. An opening 78 for the first ohmic contact 14 extends through both the first layer 76 of the charge injection barrier 75 and through the first passivation layer 12. The second layer 77 of the charge injection barrier 75 is positioned on the sidewall of the opening 13 in the first passivation layer 12 and on the sidewall of the opening 78 in the first layer 76. The second layer 77 may be formed of the same material or a different material from the first layer 76 of the charge injection barrier. For example, the second layer may be formed of an oxide or may be formed of a nitride, such as titanium nitride.

The first ohmic contact has a T-shape so that the vertical portion 46 of the first ohmic contact 14 is positioned in the opening 78 such that it is in contact with the second layer 77. The horizontal portion 47 of the first ohmic contact 14 which is positioned above the upper surface 32 of the passivation layer 12 is in direct contact with the first layer 76 of the charge injection barrier 75 at its peripheral most portions and is in direct contact with the second layer 78 at the joint between the horizontal portion 47 and the vertical portion 46. The base of the vertical portion 46 is in contact with the Group III nitride layer 11. Surface to surface contact between the first ohmic contact 14 and the passivation layer is prevented by means of both of the layers 76, 77 of the charge injection barrier 75. Different materials for the layers 76, 77 may be used to simplify manufacture.

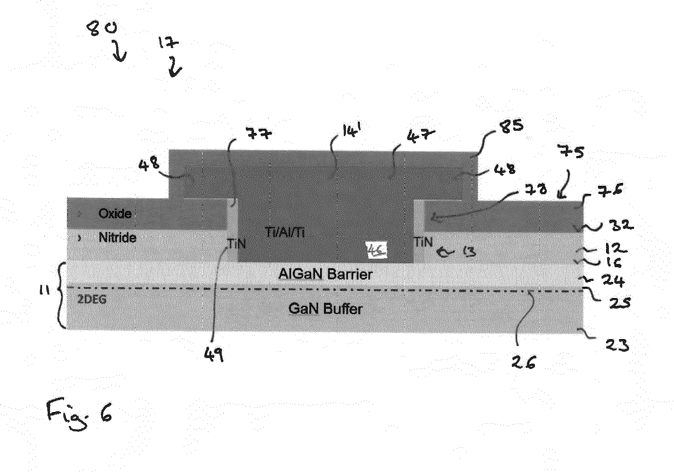

Figure 6 illustrates a schematic cross-sectional view of a portion of the Group III nitride device 80 which includes a charge injection barrier 75 having a first layer 76 and a second layer 77 as in the embodiment illustrated in figure 5. In the embodiment illustrated in figure 6, a second charge injection barrier 85 is provided which covers the outer surface of the first ohmic contact 14 and in particular the entire outer surface of the horizontal portion 47 of the ohmic contact 14 such that it is in contact with the first layer 76 of the charge injection barrier layer 75. The second charge injection barrier 86 may be formed of the same material as the first layer 76 of the first charge injection barrier 75 at the periphery of the T-shaped ohmic contact structure 14'. For example, the second charge injection barrier 86 may be formed of an oxide, for example silicon oxide. The use of the same material for the second charge injection barrier 86 and the first layer 76 of the first charge injection barrier 75 may enable an improved join between the layers to be formed so prevent current leakage from the ohmic contact structure 14 along the interface between the second charge injection barrier 86 and the first layer 76 of the first charge injection barrier 75.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Group III nitride device (10, 10', 40, 50, 60, 70, 80), comprising:
a Group III nitride layer (11);
a passivation layer (12) arranged on the Group III nitride layer (11) and comprising a first opening (13),
a first ohmic contact structure (14, 14') arranged in the first opening (13) and forming an ohmic contact to the Group III nitride layer (11);
a charge injection barrier (15, 45, 55, 65, 85) arranged between the first ohmic contact structure (14, 14') and the passivation layer (12), the charge injection barrier (15, 45, 55, 65, 85) forming no ohmic contact to the Group III nitride layer (11).

2. A Group III nitride device (10, 10', 40, 50, 60, 70, 80) according to claim 1, wherein the charge injection barrier (15, 45, 55, 65, 85) extends continuously and uninterruptedly between the first ohmic contact structure (14, 14') and the passivation layer (12) to prevent surface-to-surface contact between the first ohmic contact structure (14, 14') and the passivation layer (12).

3. A Group III nitride device (10', 40, 50, 60, 70, 80)according to claim 1 or claim 2, wherein the charge injection barrier (45, 55, 65, 85) extends continuously and uninterruptedly on side walls of the first opening (13) and over an upper surface (32) of the passivation layer (12).

4. A Group III nitride device (60) according to claim 3, wherein the charge injection barrier (65) has a lateral extent on the upper surface (32) of the passivation layer (12) such that it forms a ring-shape or a strip shape on the surface (32) of the passivation layer (12).

5. A Group III nitride device (10, 10', 40, 50, 60, 70, 80) according to one of claims 1 to 4, wherein the charge injection barrier (15, 45, 55, 65, 85) comprises at least one of the Group consisting of an oxide, a nitride, a metal nitride, TiN and a material having a work function that is higher than the work function of the first ohmic contact structure (14, 14').

6. A Group III nitride device (50, 60) according to one of claims 1 to 4, wherein the passivation layer (12) comprises a nitride and the charge injection barrier (55, 65) comprises a nitride having a different composition and/or a higher density than the nitride of the passivation layer (12).

7. A Group III nitride device (10', 40, 50, 60, 70, 80)according to one of claims 1 to 6, wherein the first ohmic contact structure (14') comprises a first portion (47) and a second portion (46), wherein the first portion (47) has a first surface and a second surface opposing the first surface, the first portion (47) extending in a transverse plane and having a width, wherein the second portion (46) protrudes from the second surface intermediate the width of the first portion (47), wherein the second portion (46) is arranged in the first opening (13) of the passivation layer (12) and the first portion (47) extends onto the upper surface (32) of the passivation layer (12) adjacent the first opening (13).

8. A Group III nitride device (80) according to claim 7, further comprising a second charge injection barrier (85) covering the first surface of the first portion (47) and a periphery of the first portion (47), the periphery extending from the first surface to the second surface.

9. A Group III nitride device (10, 10', 40, 50, 60, 70, 80) according to one of claims 1 to 8, the first ohmic contact structure (14, 14') comprises aluminium and titanium and is free of copper and free of gold.

10. A Group III nitride device (70) according to one of claims 1 to 9, wherein the charge injection barrier (75) comprises a first layer (76) arranged on an upper surface (32) of the passivation layer (12) and a second layer (77) arranged on side walls of the opening (13) in the passivation layer (12).

11. A Group III nitride device (10) according to one of claims 1 to 10, wherein the charge injection barrier (15) is arranged on the side walls of the first opening (13) and the upper surface (32) of the passivation layer (12) is exposed from the charge injection barrier (15).

12. A Group III nitride device (10, 10', 40, 50, 60, 70, 80)according to one of claims 1 to 11, wherein the Group III nitride layer (11) comprises a multilayer structure, the multilayer structure comprising a channel layer (23), a barrier layer (24) on the channel layer (23) forming a heterojunction (25) with the channel layer (23).

13. A Group III nitride device (10, 10', 40, 50, 60, 70, 80) according to claim 12, further comprising:
a second ohmic contact structure (18) arranged on and forming an ohmic contact to the multilayer Group III nitride device structure (11), and
a gate (19, 19') laterally positioned between the first ohmic contact structure (14, 14') and the second ohmic contact structure (18) and forming a gate contact to the multilayer Group III nitride device structure to form a transistor device (17, 17').

14. A Group III nitride device (10, 10', 40, 50, 60, 70, 80) according to claim 13, wherein the transistor device (17, 17') is a High Electron Mobility Transistor.

15. A Group III nitride device (10, 10', 40, 50, 60, 70, 80) according to claim 13 or claim 14, wherein the first ohmic contact structure (14, 14') is a drain contact and the second ohmic contact structure (18) is a source contact.
